# EUROPÄISCHE PATENTSCHRIFT

(11) **EP 1 664 524 B1**
(45) Veröffentlichungstag und Bekanntmachung des Hinweises auf die Patenterteilung: **14.04.2010**
(21) Anmeldenummer: 04762530.6
(22) Anmeldetag: 28.07.2004
(51) Int. Cl.: F02M 51/06, F02M 59/46, H01L 41/053, H01L 41/083, F02M 47/02

(54) **VENTILEINRICHTUNG, INSBESONDERE EIN KRAFTSTOFFEINSPRITZVENTIL FÜR EINE BRENNKRAFTMASCHINE**
VALVE MECHANISM, ESPECIALLY FUEL INJECTION VALVE FOR AN INTERNAL COMBUSTION ENGINE
SYSTEME DE SOUPAPE, NOTAMMENT SOUPAPE D'INJECTION DE CARBURANT POUR MOTEUR A COMBUSTION INTERNE

(30) Priorität: 02.09.2003 DE 10340319
(43) Veröffentlichungstag der Anmeldung: 07.06.2006
(73) Patentinhaber: ROBERT BOSCH GMBH, 70442 Stuttgart (DE)
(72) Erfinder: KEGEL, Timo, 71638 Ludwigsburg (DE)
(86) Internationale Anmeldenummer: PCT/DE2004/001685
(87) Internationale Veröffentlichungsnummer: WO 2005/024222

(56) Entgegenhaltungen:
- EP-A- 1 292 994
- WO-A-99/08330
- DE-A- 10 139 550
- DE-A- 10 140 196
- DE-A- 19 947 067

## Beschreibung

### Stand der Technik

Die Erfindung betrifft eine Ventileinrichtung insbesondere Kraftstoffeinspritzventil für eine Brennkraftmaschine, mit einem Ventilelement, dessen Schaltstellung wenigstens mittelbar vom Schaltzustand eines Piezoaktors abhängt, welcher von einer rohrförmigen und insgesamt zylindrischen Vorspanneinrichtung beaufschlagt wird, die aus einem plattenförmigen Ausgangsmaterial hergestellt ist und mindestens zwei aneinander stoßende Längsränder aufweist.

Eine Ventileinrichtung der eingangs genannten Art ist vom Markt her bekannt. Sie wird bei Kraftstoffeinspritzventilen bei Brennkraftmaschinen mit Kraftstoffdirekteinspritzung eingesetzt. Derartige Kraftstoffeinspritzventile sind an eine Kraftstoff-Sammelleitung ("Rail") angeschlossen, in der der Kraftstoff unter hohem Druck bereitgestellt wird. Sie spritzen den Kraftstoff direkt in einen ihnen jeweils zugeordneten Brennraum ein. Um eine Einspritzung durchführen zu können, wird ein Piezoaktor betätigt. Dieser beeinflusst eine Schaltstellung eines Ventilelements des Kraftstoffeinspritzventils entweder direkt, oder er steuert ein Sekundärventil an, mit dem der Druck in einem hydraulischen Steuerraum des Kraftstoffeinspritzventils beeinflusst werden kann. Der Druck im hydraulischen ein Sekundärventil an, mit dem der Druck in einem hydraulischen Steuerraum des Kraftstoffeinspritzventils beeinflusst werden kann. Der Druck im hydraulischen Steuerraum wiederum beeinflusst die Schaltstellung des Ventilelements.

Die Verwendung von Piezoaktoren hat sich bei den eingangs genannten Ventileinrichtungen aufgrund ihrer sehr kurzen Schaltzeit bewährt. Diese kurze Schaltzeit ermöglicht eine sehr präzise Einbringung des gewünschten Kraftstoffes in den Brennraum. Allerdings sind Piezoaktoren mechanisch sehr empfindlich. Um zu verhindern, dass sich der Piezoaktor bei einer Längenänderung, die durch eine Ansteuerung ausgelöst wird, selbst beschädigt oder gar zerstört, wird der Piezoaktor von vornherein mit einer Druckkraft beaufschlagt. Dies geschieht üblicherweise mittels einer Rohrfeder. Diese wird aus einem plattenförmigen Ausgangsmaterial, welches auch als "Platine" bezeichnet wird, hergestellt. Die im Endzustand aneinander stoßenden Längsränder können miteinander verschweißt werden. Dies ist jedoch aufwendig, teuer, und die Lebensdauer derartiger Schweißverbindungen ist beschränkt. Bevorzugt werden daher solche Rohrfedern eingesetzt, bei denen die Längsränder des plattenförmigen Ausgangsmaterials stumpf aneinander stoßen, jedoch nicht kraftschlüssig miteinander verbunden sind.

WO 99/08330 beschreibt einen piezoelektrischen Aktor, der durch eine Rohrfeder vorgespannt wird. Die Rohrfeder weist zwei aneinander stoßende Längsränder auf, die miteinander verschweißt sein können

Die vorliegende Erfindung hat die Aufgabe, eine Ventileinrichtung der eingangs genannten Art so weiterzubilden, dass sie eine möglichst lange Lebensdauer aufweist.

Diese Aufgabe wird bei einer Ventileinrichtung der eingangs genannten Art dadurch gelöst, dass die Vorspanneinrichtung mindestens einen Bereich aufweist, dessen Längssteifigkeit sich von der eines benachbarten Bereichs unterscheidet und der relativ zu den aneinander stoßenden Längsrändern so angeordnet ist, dass das durch die veränderte Längssteifigkeit im bereich der aneinander stoßenden Längsränder erzeugte und auf den Piezoaktor wirkende Biegemoment reduziert wird.

### Vorteile der Erfindung

Erfindungsgemäß wurde erkannt, dass sich die Längssteifigkeit der rohrförmigen Vorspanneinrichtung an jener Stelle, an der die Längsränder des plattenförmigen Ausgangsmaterials aneinander stoßen, von der Längssteifigkeit der benachbarten Bereiche unterscheidet. Dies führt dazu, dass die Rohrfeder den Piezoaktor unter Last über ihren Umfang mit unterschiedlichen Kräften beaufschlagt. Auf diese Weise wird ein Biegemoment in den Piezoaktor eingeleitet, was in ungünstigen Fällen zu einer Beschädigung des Piezoaktors oder sogar zu seiner Zerstörung führen kann.

Bei der erfindungsgemäßen Ventileinrichtung wird die Einleitung eines solchen Biegemoments in den Piezoaktor deutlich reduziert oder gänzlich ausgeschlossen. Dies geschieht zunächst dadurch, dass die Vorspanneinrichtung einen zusätzlichen Bereich aufweist, dessen Längssteifigkeit sich von jener der benachbarten Bereiche unterscheidet, und zwar vorzugsweise in der gleichen Art, wie sich auch die Längssteifigkeit im Bereich der aneinander stoßenden Längsränder von der der benachbarten Abschnitte der Rohrfeder unterscheidet. Dieser zusätzliche veränderte Bereich wird nun so angeordnet, dass das durch ihn erzeugte Biegemoment jenes, welches durch die aneinander stoßenden Längsränder erzeugt wird, wenigstens zum Teil kompensiert.

Trotz der zwangsläufig veränderten Längssteifigkeit der Rohrfeder im Bereich der aneinander stoßenden Längsränder wird so eine biegemomentfreie oder zumindest biegemomentarme Vorspannung auf den Piezoaktor aufgebracht, was für dessen Lebensdauer und für die Lebensdauer der gesamten Ventileinrichtung optimal ist.

Vorteilhafte Weiterbildungen der Erfindung sind in Unteransprüchen angegeben.

Zunächst wird vorgeschlagen, dass die aneinander stoßenden Längsränder nicht kraftschlüssig verbunden sind, und sie eine den aneinander stoßenden Längsrändern, in radialer Richtung gesehen, wenigstens in etwa gegenüberliegende und insgesamt in Längsrichtung der Vorspanneinrichtung verlaufende Ausnehmung aufweist. Sind die Längsränder nicht kraftschlüssig verbunden, bedeutet dieser Stoß eine "Schwachstelle", in der die Längssteifigkeit der Rohrfeder reduziert ist. Erfindungsgemäß wird durch die Ausnehmung eine zusätzliche und gegenüberliegende Schwachstelle geschaffen, welche das im Bereich des Stoßes erzeugte Biegemoment kompensiert. Diese Vorrichtung ist preiswert, da eine solche Rohrfeder einfache hergestellt werden kann.

Ferner wird vorgeschlagen, dass die Länge der aneinander stoßenden Längsränder, in axialer Richtung gesehen, kleiner ist als die Längserstreckung der Vorspanneinrichtung. Dies bedeutet letztlich, dass auch im Bereich der aneinander stoßenden Längsränder eine Ausnehmung vorhanden ist, was die axiale Steifigkeit der Vorspanneinrichtung in diesem Bereich an jene in dem radial gegenüberliegenden Bereich anpasst. Hierdurch wird die Symmetrie des Kraftverlaufs längs der axialen Ränder der Vorspanneinrichtung bezüglich deren Mittelachse nochmals verbessert.

Dabei ist es möglich, dass die Längsränder nur im Bereich der axialen Ränder der Vorspanneinrichtung aneinander stoßen. Dies erleichtert die Montage, sorgt für eine gleichmäßige Kontaktfläche der Vorspanneinrichtung einerseits zum Piezoaktor und andererseits zu der entsprechenden Gegenfläche und verhindert einen unerwünschten Versatz der Ränder der Vorspanneinrichtung unter Last.

Möglich ist aber auch, dass die Längsränder nur im Bereich eines axialen Rands der Vorspanneinrichtung aneinander stoßen. Dies vereinfacht die Herstellung der erfindungsgemäßen Vorspanneinrichtung.

Alternativ hierzu ist auch denkbar, dass die Längsränder nur im Bereich der axialen Mitte der Vorspanneinrichtung aneinander stoßen. Auch dies ist fertigungstechnisch leicht realisierbar und gestattet eine in axialer Richtung der Vorspanneinrichtung symmetrische Ausgestaltung.

Besonders bevorzugt ist jene Ausgestaltung der erfindungsgemäßen Kraftstoff-Einspritzvorrichtung, bei welcher die aneinander stoßenden Längsränder der Vorspanneinrichtung in deren Längsrichtung durch mindestens eine Ausnehmung begrenzt werden, welche bezüglich Lage und/oder Geometrie ähnlich oder identisch ist zu der radial gegenüberliegenden Ausnehmung. Hierdurch wird eine beinahe vollständige Symmetrie des Kraftverlaufs längs der Ränder der Vorspanneinrichtung bezüglich deren Mittelachse geschaffen, so dass praktisch überhaupt kein Biegemoment in den Piezoaktor eingeleitet wird.

Eine weitere vorteilhafte Ausgestaltung der erfindungsgemäßen Kraftstoff-Einspritzvorrichtung sieht vor, dass nur in Höhe jenes axialen Bereichs der Vorspanneinrichtung, in dem die Längsränder aneinander stoßen, keine über die Oberfläche der Vorspanneinrichtung verteilt angeordnete Öffnungen vorhanden sind. Derartige Öffnungen, die bisweilen auch als "Knochen" bezeichnet werden, da ihre Form oft der eines Knochens entspricht, ermöglichen eine axiale Verformung der rohrförmigen Vorspanneinrichtung, ohne dass es zur Wellenbildung der Oberfläche kommt. Durch die erfindungsgemäße Maßnahme wird eine Vorspanneinrichtung geschaffen, bei der zwar derartige Öffnungen vorhanden sind, bei der aber dennoch eine gegenüber der Mittelachse der Vorspanneinrichtung vollkommen symmetrische Ausgestaltung möglich ist, so dass im Betrieb der Ventileinrichtung nur vernachlässigbare oder überhaupt keine Biegemomente von der Vorspanneinrichtung in den Piezoaktor eingeleitet werden.

Eine besonders preisgünstige Herstellung der erfindungsgemäßen Ventileinrichtung wird dadurch erreicht, dass die Ausnehmung oder die Ausnehmungen der Vorspanneinrichtung aus dem plattenförmigen Ausgangsmaterial ausgestanzt sind.

### Zeichnung

Nachfolgend werden besonders bevorzugte Ausführungsbeispiele anhand der beiliegenden Zeichnung näher erläutert. In der Zeichnung zeigen:
- Figur 1: eine schematische und stark vereinfachte Darstellung eines Kraftstoffeinspritzventils mit einem Schaltventil mit einem Piezoaktor, der von einer Vorspanneinrichtung beaufschlagt wird;
- Figur 2: eine perspektivische Darstellung eines ersten Ausführungsbeispiels der Vorspanneinrichtung von Figur 1;
- Figur 3: eine Darstellung der Abwicklung der Vorspanneinrichtung von Figur 2;
- Figur 4: eine Darstellung ähnlich Figur 2 eines zweiten Ausführungsbeispiels;
- Figur 5: eine Darstellung ähnlich Figur 3 des Ausführungsbeispiels von Figur 4;
- Figur 6: eine Darstellung ähnlich Figur 2 eines dritten Ausführungsbeispiels; und
- Figur 7: eine Darstellung ähnlich Figur 3 des Ausführungsbeispiels von Figur 6.

### Beschreibung der Ausführungsbeispiele

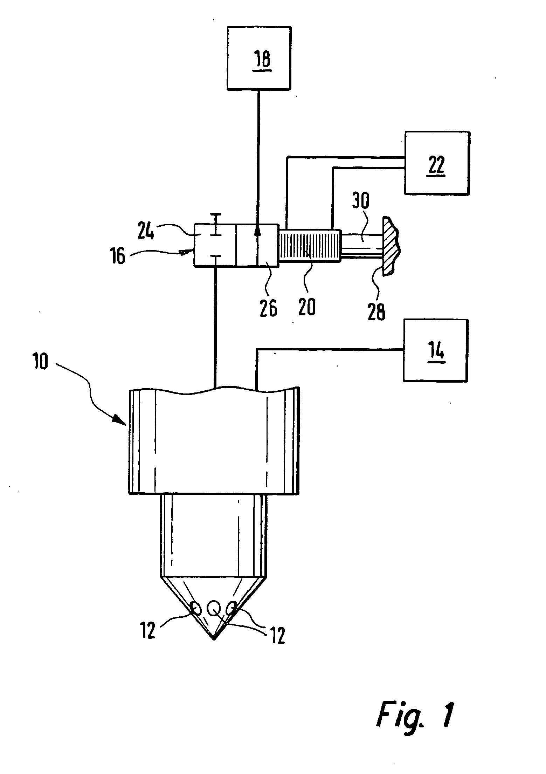

Ein Kraftstoffeinspritzventil trägt in Figur 1 insgesamt das Bezugszeichen 10. Mit ihm wird Kraftstoff direkt in einen Brennraum (nicht dargestellt) einer Brennkraftmaschine eingespritzt. Hierzu verfügt das Kraftstoffeinspritzventil 10 über Kraftstoff-Austrittsöffnungen 12. Im Inneren des Kraftstoffeinspritzventils 10 ist ein in Figur 1 nicht sichtbares Ventilelement vorhanden, durch welches die Kraftstoff-Austrittsöffnungen 12 mit einem Hochdruckanschluss 14 verbunden oder von diesem getrennt werden können. Der Hochdruckanschluss 14 des Kraftstoffeinspritzventils 10 ist mit einer Kraftstoff-Sammelleitung (nicht dargestellt) verbunden, welche gemeinhin auch als "Rail" bezeichnet wird.

Die Schaltstellung des Ventilelements des Kraftstoffeinspritzventils 10 wird hydraulisch eingestellt. Hierzu kann ein Steuerraum (nicht dargestellt) über ein Schaltventil 16 mit einem Niederdruckanschluss 18 verbunden oder von diesem getrennt werden. Das Funktionsprinzip eines solchen "hubgesteuerten" Kraftstoffeinspritzventils 10 kann beispielsweise aus der DE 101 22 256 A1 entnommen werden.

Das Schaltventil 16 umfasst einen Piezoaktor 20, der mit einer elektrischen Steuereinrichtung 22 verbunden ist. Durch die Steuereinrichtung 22 kann an den Piezoaktor 20 eine Spannung angelegt werden, so dass sich dessen Ladezustand ändert. Hierdurch dehnt sich der Piezoaktor 20 aus oder er zieht sich wieder zusammen, wodurch bewirkt wird, dass das Schaltventil 16 entweder in der einen, geschlossenen Schaltstellung 24 oder in der anderen, geöffneten Schaltstellung 26 ist.

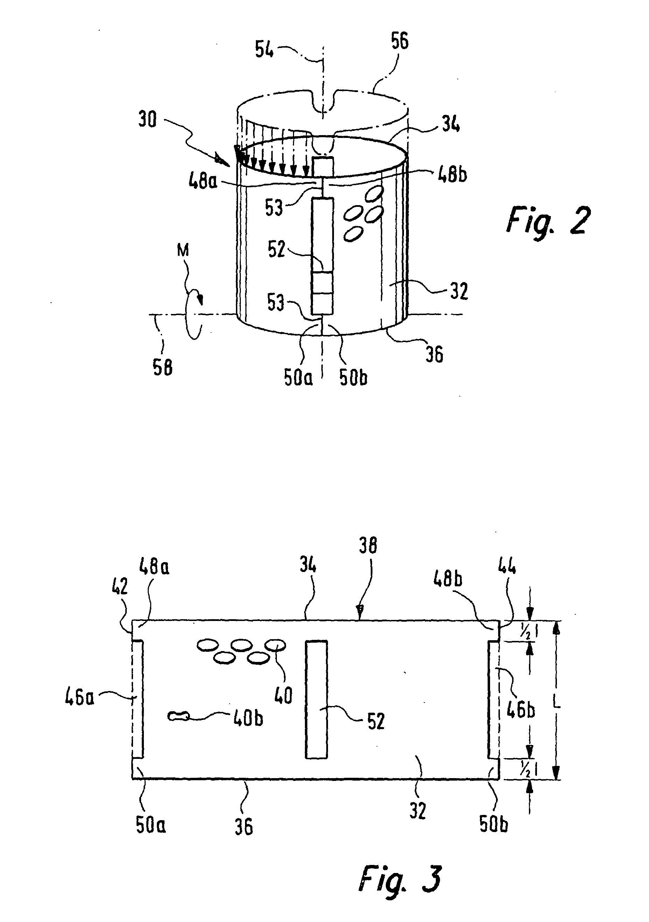

Der Piezoaktor 20 ist mechanisch sehr empfindlich. Damit er bei einer schnellen Längenänderung nicht beschädigt wird, wird er mit einer konstanten Druckkraft beaufschlagt. Hierzu wird zwischen dem Piezoaktor 20 und einer stationären Gegenfläche 28 eine rohrförmige und insgesamt zylindrische Vorspanneinrichtung 30 verspannt. Ein erstes Ausführungsbeispiel einer solchen Vorspanneinrichtung 30 wird nun unter Bezugnahme auf die Figuren 2 und 3 näher erläutert:

Wie aus Figur 2 hervorgeht, handelt es sich bei der Vorspanneinrichtung 30 um eine insgesamt zylindrische Rohrfeder. Diese weist eine Mantelfläche 32 auf, sowie einen in Figur 2 oberen Rand 34 und einen in Figur 2 unteren Rand 36. Die auch nachfolgend verwendeten Bezeichnungen "oben" und "unten" beziehen sich immer auf die Zeichnung. Es versteht sich, dass die Vorspanneinrichtung 30 tatsächlich auch anders eingebaut werden kann.

Mit dem oberen Rand 34 liegt die Vorspanneinrichtung 30 an der Gegenfläche 28, mit dem unteren Rand 36 am Piezoaktor 20 an. Wie insbesondere aus der in Figur 3 gezeigten Abwicklung hervorgeht, ist die Vorspanneinrichtung 30 aus einem plattenförmigen Ausgangsmaterial 38 hergestellt. In dieses werden zunächst über die gesamte Fläche 32 verteilt angeordnete Öffnungen 40 eingestanzt. Diese sind in axialer Richtung gesehen versetzt zueinander angeordnet. In den Figuren 2 und 3 sind der Einfachheit halber nur einige dieser Öffnungen 40 dargestellt, obwohl die gesamte Fläche 32 mit diesen Öffnungen 40 durchsetzt ist. Die Öffnungen 40 können kreisförmige, ovale, oder elliptische Gestalt aufweisen, sie können jedoch auch in Form eines so genannten "Knochens" ausgebildet sein, wie in Figur 3 unter dem Bezugszeichen 40b angedeutet ist.

Das plattenförmige Ausgangsmaterial 38 weist einen in Figur 3 linken Rand 42 und einen rechten Rand 44 auf. An beiden Rändern 42 und 44 wird eine Ausnehmung 46a beziehungsweise 46b herausgestanzt (siehe gestrichelte Linien). Diese beginnen in einem geringen Abstand vom unteren Rand 36 und enden in einem geringen Abstand vom oberen Rand 34. Somit bleiben im Bereich des oberen Rands 34 seitlich abragende Stege 48a beziehungsweise 48b und im Bereich des unteren Rands 36 ebenfalls seitlich abragende Stege 50a und 50b übrig. In der Mitte zwischen den seitlichen Rändern 42 und 44 ist eine schlitzartige Ausnehmung 52 ausgestanzt, welche die gleiche Höhe hat wie die beiden Ausnehmungen 46a und 46b und welche die doppelte Breite hat als eine der beiden Ausnehmungen 46a und 46b.

Das plattenförmige Ausgangsmaterial 38 wird dann gerollt oder gebogen, bis sich die seitlich abragenden Stege 48a und 48b beziehungsweise 50a und 50b jeweils an einem Stoß 53 berühren. Es ergibt sich die in Figur 2 gezeigte Rohrfeder 30. Die zwischen den Stegen 48a,b und 50a,b und den beiden Ausnehmungen 46a und 46b gebildete Ausnehmung hat insgesamt die gleiche Höhe und Breite wie die Ausnehmung 52. Die nun aneinander stoßenden Stege 48a und 48b beziehungsweise 50a und 50b werden nicht miteinander verschweißt, sondern stoßen, ohne kraftschlüssig miteinander verbunden zu sein, stumpf aneinander. Die Gesamtlänge 1 des Stoßes 53 ist deutlich kleiner als die Länge L der Rohrfeder 30 (siehe Figur 3).

Im Bereich des Stoßes 53 zwischen den Stegen 48a und 48b beziehungsweise 50a und 50b ist die Steifigkeit der Rohrfeder 30 in Längsrichtung 54 gegenüber der benachbarten Mantelfläche 32 geschwächt. Entsprechend ergibt sich an dieser Stelle ein deutlicher Abfall der in Längsrichtung 54 von der Rohrfeder 30 auf den Piezoaktor 20 aufbringbaren Druckkraft. Der Verlauf der in Längsrichtung 54 wirkenden Druckkraft ist in Figur 2 durch eine strichpunktierte Linie 56 angedeutet. Dadurch, dass jedoch zu der Ausnehmung 46 radial exakt gegenüberliegend eine identische Ausnehmung 52 vorhanden ist, fällt auch in diesem Bereich die Druckkraft 56 gegenüber den benachbarten Bereichen entsprechend ab. Der Druckkraftverlauf 56 ist somit insgesamt gegenüber der Längsachse 54 der Rohrfeder 30 im Wesentlichen symmetrisch, so dass ein Biegemoment M, welches um eine quer zur Längsachse 54 verlaufende Achse 58 anliegt, nur verschwindend gering ist. Somit wird durch die Rohrfeder 30 auf den Piezoaktor 20 nur ein sehr geringes Biegemoment M ausgeübt, was für dessen Lebensdauer günstig ist.

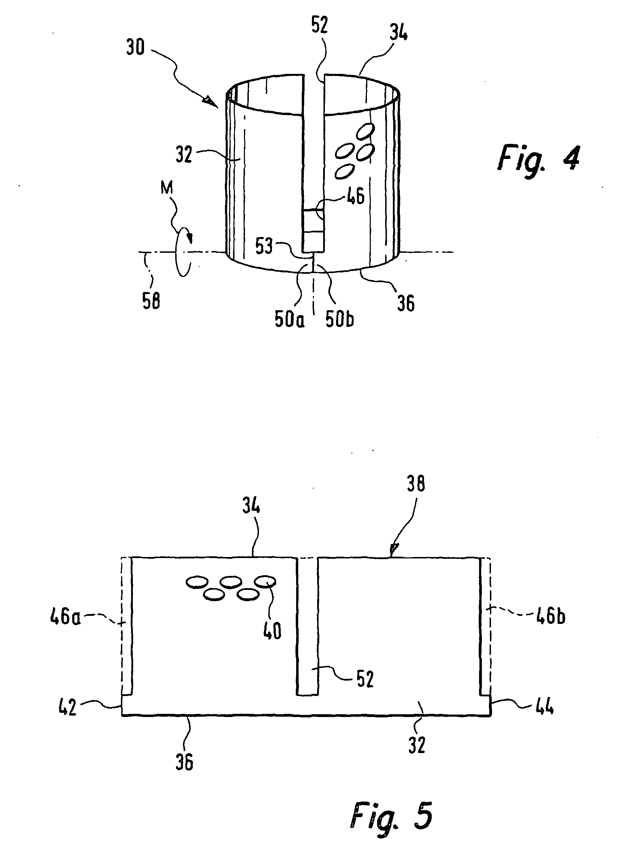

Eine abgewandelte Ausführungsform einer Rohrfeder 30 ist in den Figuren 4 und 5 gezeigt. Dabei tragen solche Elemente und Bereiche, welche äquivalente Funktionen zu Elementen und Bereichen aufweisen, die bereits im Zusammenhang mit den Figuren 2 und 3 erläutert worden sind, die gleichen Bezugszeichen. Sie sind nicht nochmals im Detail erläutert. Aus Gründen der Übersichtlichkeit sind ferner nicht alle Bezugszeichen eingetragen.

Der wesentliche Unterschied der in den Figuren 4 und 5 gezeigten Rohrfeder 30 zu jener der Figuren 2 und 3 betrifft die Tatsache, dass im Bereich des oberen Randes 34 keine seitlich abragenden Stege vorhanden sind. Auch die Ausnehmung 52 erstreckt sich bis zum oberen Rand 34. Der Steifigkeitsunterschied der Rohrfeder 30 im Bereich des Stoßes 53 gegenüber dem radial gegenüberliegenden Bereich wird hierdurch nochmals verkleinert. Das resultierende Biegemoment M ist daher nochmals kleiner.

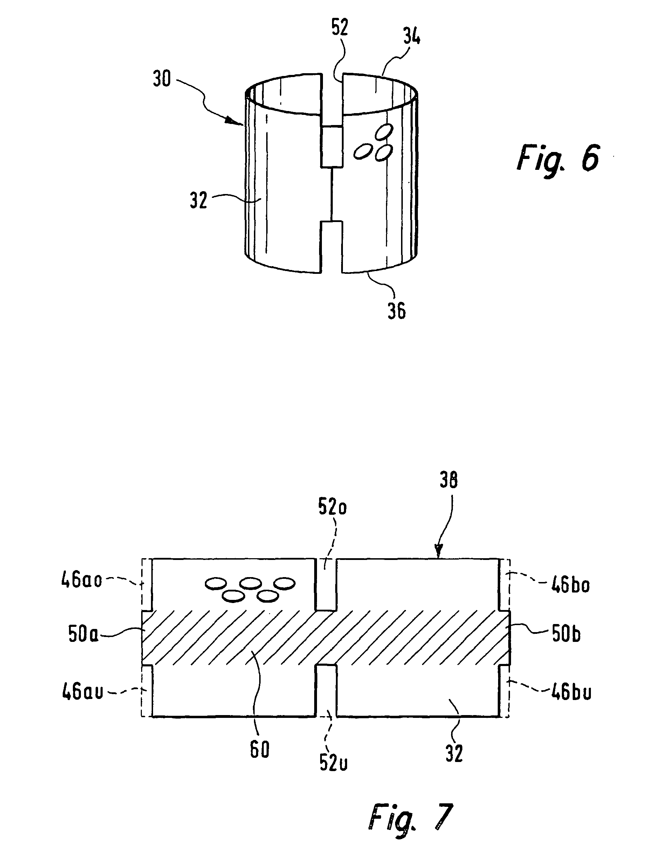

Eine nochmals andere Variante einer Rohrfeder 30 ist in den Figuren 6 und 7 gezeigt. Auch hier gilt, dass solche Elemente und Bereiche, welche äquivalente Funktionen zu Elementen und Bereichen haben, die bereits im Zusammenhang mit den obigen Ausführungsbeispielen erwähnt worden sind, die gleichen Bezugszeichen tragen und nicht nochmals im Detail erläutert sind.

Bei der in den Figuren gezeigten Rohrfeder 30 sind die seitlich abragenden Stege 50a und 50b in der axialen Mitte des plattenförmigen Ausgangsmaterials 38 und somit auch in der axialen Mitte der Rohrfeder 30 angeordnet. Oberhalb der Stege 50a und 50b sind daher obere Ausnehmungen 46ao und 46bo vorhanden, wohingegen die unterhalb der Stege 50a und 50b vorhandenen Ausnehmungen die Bezugszeichen 46au beziehungsweise 46bu tragen. Auch die mittlere Ausnehmung 52 ist nun zweigeteilt und weist eine sich vom unteren Rand 36 aus erstreckende Ausnehmung 52u und eine sich vom oberen Rand 34 erstreckende Ausnehmung 52o auf.

In Figur 7 ist ein auf halber Höhe liegender Bereich 60, der in axialer Richtung gesehen exakt die Höhe der seitlich abragenden Stege 50a und 50b aufweist, welche wiederum dem Abstand zwischen den mittleren Ausnehmungen 52o und 52u entspricht, schraffiert dargestellt. In diesem Bereich sind keine Öffnungen 40 vorhanden. Dies führt zu einer nochmaligen Vergleichmäßigung der Steifigkeit der Rohrfeder 30 in Umfangsrichtung.

In den oben beschriebenen Ausführungsbeispielen umfasst die Rohrfeder 30 zwei radial gegenüberliegende Ausnehmungen 46 und 52. Grundsätzlich ist aber jede beliebige Anzahl von Ausnehmungen denkbar, solange sie so über den Umfang der Rohrfeder verteilt angeordnet sind, dass das Biegemoment, welches durch die aneinander stoßenden Längsränder 42 und 44 erzeugt wird, reduziert wird.

## Patentansprüche

1. Kraftstoff-Einspritzvorrichtung (10) für eine Brennkraftmaschine, mit einem Ventilelement, dessen Schaltstellung wenigstens mittelbar vom Schaltzustand eines Piezoaktors (20) abhängt, welcher von einer rohrförmigen und insgesamt zylindrischen Vorspanneinrichtung (30) beaufschlagt wird, die aus einem plattenförmigen Ausgangsmaterial (38) hergestellt ist und mindestens zwei in einem ersten Bereich aneinander stoßende Längsränder (42, 44) aufweist, so dass in diesem ersten Bereich die Längssteifigkeit der Vorspannvorrichtung (30) gegenüber einem benachbarten zweiten Bereich verändert ist, **dadurch gekennzeichnet, dass** die Vorspanneinrichtung (30) mindestens einen dritten Bereich (52) aufweist, dessen Längssteifigkeit sich von der eines benachbarten Bereichs (32) unterscheidet und der relativ zu den aneinander stoßenden Längsrändern (42, 44) des ersten Bereichs so angeordnet ist, dass das durch die veränderte Längssteifigkeit im ersten Bereich der aneinander stoßenden Längsränder (42, 44) erzeugte und auf den Piezoaktor (20) wirkende Biegemoment (M) reduziert wird.

2. Ventileinrichtung nach Anspruch 1, **dadurch gekennzeichnet, dass** die aneinander stoßenden Längsränder (42, 44) nicht kraftschlüssig verbunden sind, und sie eine den aneinander stoßenden Längsrändern (42, 44), in radialer Richtung gesehen, wenigstens in etwa gegenüberliegende und insgesamt in Längsrichtung (54) der Vorspanneinrichtung (30) verlaufende Ausnehmung (52) aufweist.

3. Kraftstoff-Einspritzvorrichtung (10) nach Anspruch 2, **dadurch gekennzeichnet, dass** die Länge (1) der aneinander stoßenden Längsränder (42, 44) der Vorspanneinrichtung (30), in axialer Richtung gesehen, kleiner ist als die Gesamt-Längserstreckung (L) der Vorspanneinrichtung (30).

4. Kraftstoff-Einspritzvorrichtung (10) nach Anspruch 3, **dadurch gekennzeichnet, dass** die Längsränder (42, 44) der Vorspanneinrichtung nur im Bereich der axialen Ränder (34, 46) der Vorspanneinrichtung (30) aneinander stoßen.

5. Kraftstoff-Einspritzvorrichtung (10) nach Anspruch 3, **dadurch gekennzeichnet, dass** die Längsränder (42, 44) der Vorspanneinrichtung (30) nur im Bereich eines axialen Rands (36) der Vorspanneinrichtung (30) aneinander stoßen.

6. Kraftstoff-Einspritzvorrichtung (10) nach Anspruch 3, **dadurch gekennzeichnet, dass** die Längsränder (42, 44) der Vorspanneinrichtung (30) nur im Bereich der axialen Mitte der Vorspanneinrichtung (30) aneinander stoßen.

7. Kraftstoff-Einspritzvorrichtung (10) nach einem der Ansprüche 3 bis 6, **dadurch gekennzeichnet, dass** die aneinander stoßenden Längsränder (42, 44) der Vorspanneinrichtung (30) in deren Längsrichtung (54) durch mindestens eine Ausnehmung (46) begrenzt werden, welche bezüglich Lage und/oder Geometrie ähnlich oder identisch ist zu der radial gegenüberliegenden Ausnehmung (52).

8. Kraftstoff-Einspritzvorrichtung (10) nach einem der Ansprüche 3 bis 7, **dadurch gekennzeichnet, dass** nur in Höhe jenes axialen Bereichs (60) der Vorspanneinrichtung (30), in dem die Längsränder (42, 44) aneinander stoßen, keine über die Oberfläche (32) der Vorspanneinrichtung (30) verteilt angeordnete Öffnungen (40) vorhanden sind.

9. Kraftstoff-Einspritzvorrichtung (10) nach einem der vorhergehenden Ansprüche, **dadurch gekennzeichnet, dass** die Ausnehmung oder die Ausnehmungen (46, 52) der Vorspanneinrichtung (30) aus dem plattenförmigen Ausgangsmaterial (38) ausgestanzt sind.

## Claims

1. Fuel injection apparatus (10) for an internal combustion engine, having a valve element whose switching position is at least indirectly dependent on the switching state of a piezoelectric actuator (20) which is acted on by a tubular and, overall, cylindrical preload device (30) which is produced from a plate-shaped starting material (38) and which has at least two longitudinal edges (42, 44) which abut against one another in a first region such that, in said first region, the longitudinal stiffness of the preload device (30) is changed in relation to an adjacent second region, **characterized in that** the preload device (30) has at least one third region (52) whose longitudinal stiffness differs from that of an adjacent region (32) and which is arranged relative to the longitudinal edges (42, 44), which abut against one another, of the first region in such a way that the bending moment (M), which is generated as a result of the changed longitudinal stiffness in the first region of the longitudinal edges (42, 44) abutting against one another and which acts on the piezoelectric actuator (20), is reduced.

2. Valve device according to Claim 1, **characterized in that** the longitudinal edges (42, 44) which abut against one another are not connected in a frictionally engaging manner, and said valve device has a recess (52) which is situated at least approximately opposite the longitudinal edges (42, 44), which abut against one another, as viewed in the radial direction and which runs, overall, in the longitudinal direction (54) of the preload device (30).

3. Fuel injection apparatus (10) according to Claim 2, **characterized in that** the length (1) of the longitudinal edges (42, 44), which abut against one another, of the preload device (30), as viewed in the axial direction, is smaller than the overall longitudinal extent (L) of the preload device (30).

4. Fuel injection apparatus (10) according to Claim 3, **characterized in that** the longitudinal edges (42, 44) of the preload device abut against one another only in the region of the axial edges (34, 46) of the preload device (30).

5. Fuel injection apparatus (10) according to Claim 3, **characterized in that** the longitudinal edges (42, 44) of the preload device (30) abut against one another only in the region of one axial edge (36) of the preload device (30).

6. Fuel injection apparatus (10) according to Claim 3, **characterized in that** the longitudinal edges (42, 44) of the preload device (30) abut against one another only in the region of the axial centre of the preload device (30).

7. Fuel injection apparatus (10) according to one of Claims 3 to 6, **characterized in that** the longitudinal edges (42, 44), which abut against one another, of the preload device (30) are delimited in their longitudinal direction (54) by at least one recess (46) which, with regard to position and/or geometry, is similar or identical to the radially opposite recess (52).

8. Fuel injection apparatus (10) according to one of Claims 3 to 7, **characterized in that** openings (40) arranged distributed over the surface (32) of the preload device (30) are not provided only at the level of that axial region (60) of the preload device (30) in which the longitudinal edges (42, 44) abut against one another.

9. Fuel injection apparatus (10) according to one of the preceding claims, **characterized in that** the recess or recesses (46, 52) of the preload device (30) are punched out of the plate-shaped starting material (38).

## Revendications

1. Dispositif d'injection de carburant (10) pour un moteur à combustion interne, comprenant un élément de soupape, dont la position de commutation dépend au moins de manière indirecte de l'état de commutation d'un actionneur piézoélectrique (20), qui est sollicité par un dispositif de précontrainte (30) de forme tubulaire et dans l'ensemble cylindrique, qui est fabriqué à partir d'un matériau de départ (38) en forme de plaque, et qui présente au moins deux bords longitudinaux (42, 44) bout à bout dans une première région, de sorte que dans cette première région, la rigidité longitudinale du dispositif de précontrainte (30) soit modifiée par rapport à une deuxième région adjacente, **caractérisé en ce que** le dispositif de précontrainte (30) présente au moins une troisième région (52) dont la rigidité longitudinale se distingue de celle d'une région adjacente (32) et qui est disposée par rapport aux bords longitudinaux bout à bout (42, 44) de la première région de telle sorte que le couple de flexion (M) produit par la rigidité longitudinale modifiée dans la première région des bords longitudinaux bout à bout (42, 44) et agissant sur l'actionneur piézoélectrique (20) soit réduit.

2. Dispositif de soupape selon la revendication 1, **caractérisé en ce que** les bords longitudinaux bout à bout (42, 44) ne sont pas connectés par engagement par force, et **en ce qu'**i présente un évidement (52) au moins approximativement opposé aux bords longitudinaux bout à bout (42, 44), vu dans la direction radiale, et s'étendant dans l'ensemble dans la direction longitudinale (54) du dispositif de précontrainte (30).

3. Dispositif d'injection de carburant (10) selon la revendication 2, **caractérisé en ce que** la longueur (1) des bords longitudinaux bout à bout (42, 44) du dispositif de précontrainte (30), vu dans la direction axiale, est plus courte que l'étendue en longueur totale (L) du dispositif de précontrainte (30).

4. Dispositif d'injection de carburant (10) selon la revendication 3, **caractérisé en ce que** les bords longitudinaux (42, 44) du dispositif de précontrainte sont bout à bout seulement dans la région des bords axiaux (34, 46) du dispositif de précontrainte (30).

5. Dispositif d'injection de carburant (10) selon la revendication 3, **caractérisé en ce que** les bords longitudinaux (42, 44) du dispositif de précontrainte (30) sont bout à bout seulement dans la région d'un bord axial (36) du dispositif de précontrainte (30).

6. Dispositif d'injection de carburant (10) selon la revendication 3, **caractérisé en ce que** les bords longitudinaux (42, 44) du dispositif de précontrainte (30) sont bout à bout seulement dans la région du centre axial du dispositif de précontrainte (30).

7. Dispositif d'injection de carburant (10) selon l'une quelconque des revendications 3 à 6, **caractérisé en ce que** les bords longitudinaux bout à bout (42, 44) du dispositif de précontrainte (30) sont limités dans leur direction longitudinale (54) par au moins un évidement (46), qui, en termes de position et/ou de géométrie, est similaire ou identique à l'évidement radialement opposé (52).

8. Dispositif d'injection de carburant (10) selon l'une quelconque des revendications 3 à 7, **caractérisé en ce que** seulement à la hauteur de la région axiale (60) du dispositif de précontrainte (30) dans laquelle les bords longitudinaux (42, 44) sont bout à bout, il n'y a pas d'ouvertures (40) réparties sur la surface (32) du dispositif de précontrainte (30).

9. Dispositif d'injection de carburant (10) selon l'une quelconque des revendications précédentes, **caractérisé en ce que** l'évidement ou les évidements (46, 52) du dispositif de précontrainte (30) sont estampés dans le matériau de départ (38) en forme de plaque.
